(19) Europäisches Patentamt / European Patent Office / Office européen des brevets

(11) **EP 3 675 356 B1**

(12) **FASCICULE DE BREVET EUROPEEN**

(45) Date de publication et mention de la délivrance du brevet:
**06.07.2022 Bulletin 2022/27**

(21) Numéro de dépôt: **19219479.3**

(22) Date de dépôt: **23.12.2019**

(51) Classification Internationale des Brevets (IPC):
**H03H 7/01** *(2006.01)*   **H03H 7/54** *(2006.01)*
**H03H 7/46** *(2006.01)*   **H03H 11/12** *(2006.01)*
**H03H 11/34** *(2006.01)*

(52) Classification Coopérative des Brevets (CPC):
**H03H 7/0153; H03H 7/0161; H03H 7/54;**
H03H 7/465; H03H 11/1291; H03H 11/342

(54) **PROCEDE POUR CALIBRER UN FILTRE A FREQUENCE VARIABLE**

VERFAHREN ZUM KALIBRIEREN EINES FILTERS MIT VARIABLER FREQUENZ

METHOD FOR CALIBRATING A VARIABLE FREQUENCY FILTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.12.2018 FR 1874330**

(43) Date de publication de la demande:
**01.07.2020 Bulletin 2020/27**

(73) Titulaire: **THALES**
**92400 Courbevoie (FR)**

(72) Inventeurs:
• **BOURSIER, Olivier**
  **49309 Cholet (FR)**
• **PETIT, Maïté**
  **49309 Cholet (FR)**

(74) Mandataire: **Marks & Clerk France**
**Immeuble "Visium"**
**22, avenue Aristide Briand**
**94117 Arcueil Cedex (FR)**

(56) Documents cités:
**US-A1- 2004 130 414     US-A1- 2008 224 792**
**US-A1- 2010 244 945     US-A1- 2013 065 542**

**Description**

L'invention concerne un procédé et un système permettant de calibrer un ou plusieurs filtres à fréquence variable. Elle est notamment utilisée pour calibrer des filtres tractables, dont la fréquence centrale est variable, et notamment des filtres passe-bande tractables en tension, c'est-à-dire dont la valeur de fréquence est régulée par application d'une tension.

L'un des problèmes techniques est le calibrage des filtres passe-bande tractables en tension qui sont présents, par exemple, dans une chaîne radio.

Pour rappel, un filtre tractable en tension est un filtre dont la fréquence centrale varie en fonction de la tension qu'on lui applique. Chaque filtre étant légèrement différent, la correspondance entre la tension appliquée sur le filtre et sa fréquence centrale n'est pas exactement connue, d'autant plus que celle-ci varie en fonction de la température.

Le calibrage est donc nécessaire d'un filtre à l'autre et, suivant la température ambiante, une même tension ne va pas donner exactement la même fréquence centrale. Cette opération est en général réalisée en sortie de production des équipements, mais elle peut aussi être réalisée à n'importe quel moment de la vie du produit.

A la connaissance du demandeur, le calibrage des composants radio dans les équipements est réalisé sur des bancs externes à l'aide d'appareils de mesure.

Pour le calibrage d'équipement, le brevet US7932844 présente une méthode itérative pour calibrer des filtres passe-bas avec une chaîne radio spécifique. Un des inconvénients est que cette chaîne radio spécifique ne correspond pas à une chaîne classique d'émission ou de réception radio, ce qui signifie qu'il faut adapter la chaîne radio de l'équipement pour pouvoir l'appliquer. Lorsqu'une chaîne radio spécifique n'est pas implémentée, il faut utiliser des appareils de mesure externe pour le calibrage et la vérification des composants radio. L'enseignement technique de ce brevet nécessite de modifier la chaîne et l'utilisation d'appareils de contrôle extérieurs. De plus, son enseignement n'est pas adapté au calibrage des filtres tractables. Autres documents concernant le même domaine technique sont US2013/065542A1 ou US2010/244945A1.

Dans la présente invention, on appelle code la valeur numérique envoyée par le système de contrôle au convertisseur numérique analogique qui pilote le filtre tractable en tension en convertissant ce code en une tension qui est appliquée sur le filtre.

De manière générale, la notion de code peut représenter : la tension appliquée sur le filtre, le courant appliqué sur le filtre ou par analogie la fréquence centrale du filtre.

L'invention concerne un procédé selon la revendication 1.

Pour initialiser les étapes du procédé, on utilise par exemple une valeur de code contenue dans une table de calibrage obtenue de manière traditionnelle ou une valeur de code moyennée sur plusieurs exemplaires.

L'invention concerne aussi un système pour calibrer un filtre à fréquence variable caractérisé en ce qu'il comporte un dispositif de gestion configuré pour faire varier la fréquence centrale dudit filtre, un capteur de température, un dispositif émetteur d'un signal, un dispositif adapté à mesurer la valeur de la puissance du signal après passage dans ledit filtre, un dispositif programmable configuré pour exécuter les étapes du procédé selon l'invention.

Le système peut comporter au moins les éléments suivants :

- une chaîne d'émission comprenant un convertisseur numérique analogique relié à un amplificateur de signal et à un filtre positionné en amont d'une antenne,
- une chaîne de réception comprenant un amplificateur positionné en amont d'un filtre dont la fréquence centrale est variable, et un convertisseur analogique numérique,
- ladite antenne est liée avec un premier commutateur configuré pour prendre deux positions afin de sélectionner la voie d'émission ou la voie de réception suivant un ordre donné par un dispositif de gestion et de commande, un deuxième commutateur et un troisième commutateur configurés pour prendre deux positions, selon la voie sélectionnée, respectivement voie émission et voie réception, lesdits deux commutateurs sont positionnés en amont d'un premier filtre constituant ainsi une voie commune à la voie d'émission et à la voie de réception.

Le dispositif de gestion et de commande peut être un dispositif programmable de type FPGA (Field Programmable Gate Array) configuré pour agir sur les commutateurs afin d'activer la chaîne d'émission ou la chaîne de calibrage et de contrôle du bon fonctionnement de la chaîne radio.

Le système peut comporter un composant CNA relié au dispositif programmable de type FPGA, ledit CNA recevant un code émis par le FPGA afin de le convertir en une tension appliquée au filtre tractable afin de générer une table contenant les valeurs des codes aux températures requises et aux fréquences requises d'une table de calibrage.

Le filtre à calibrer est, par exemple, un filtre tractable passe-bande.

Les dessins annexés illustrent l'invention :

[Fig. 1] est un synoptique des étapes de calibrage selon l'invention,

[Fig.2] représente le calibrage d'un filtre,

[Fig.3] est un exemple d'organigramme des étapes du procédé selon l'invention,

[Fig.4A] illustre la mesure de puissance en sortie d'un filtre à l'initialisation,

[Fig.4B] illustre la mesure de puissance en sortie d'un filtre et le calibrage en utilisant la méthode de la sécante,

[Fig.5], un exemple de mise en œuvre du calibrage de filtres tractables dans une chaîne radio,

[Fig.6], un exemple de mise en œuvre du calibrage de filtres tractables dans une chaîne radio,

[Fig.7] représente un exemple d'architecture FPGA permettant d'intégrer le procédé selon l'invention sur une architecture FPGA déjà existante,

[Fig.8] représente un exemple d'architecture FPGA adaptée pour la mise en œuvre du procédé selon l'invention, et

[Fig.9] représente un diagramme de machine à état pour les étapes de calibrage.

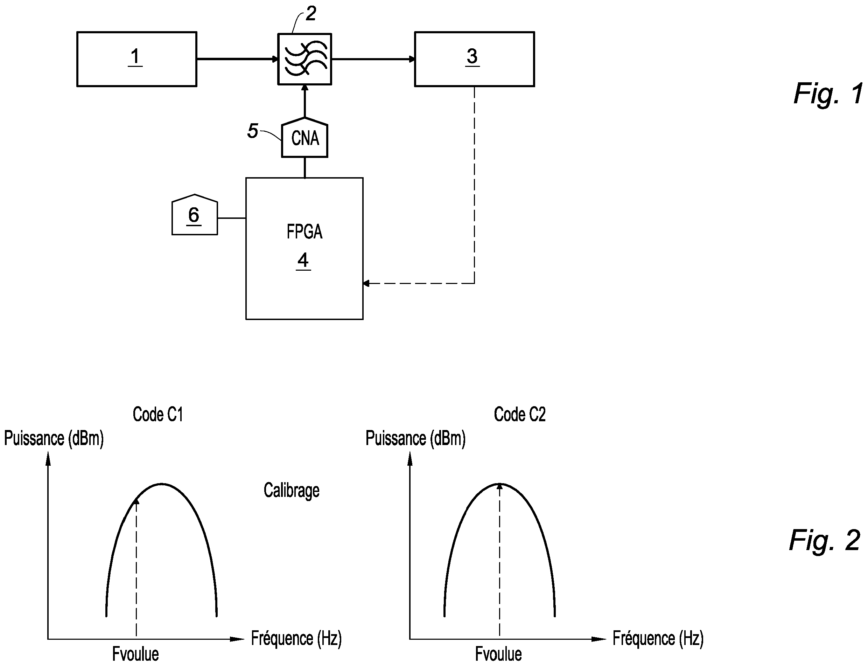

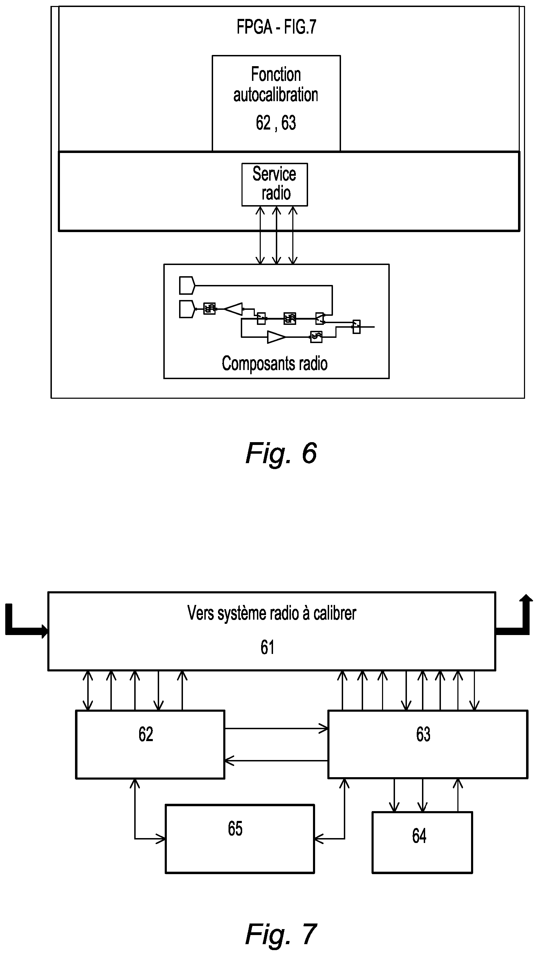

La figure 1 est un synoptique pour illustrer les étapes du procédé de calibrage selon l'invention. Une chaîne 1, disposée en amont d'un filtre tractable à calibrer 2, est configurée pour émettre un signal vers le filtre tractable à calibrer. Le signal en sortie du filtre est transmis à une chaîne 3 disposée en aval du filtre et adaptée à mesurer la valeur de la puissance ou d'un paramètre représentatif du filtre. La mesure de puissance est transmise à un dispositif 4 de type FPGA programmé pour exécuter les étapes du procédé selon l'invention. Un convertisseur de type numérique analogique, CNA, 5, va convertir les signaux de commande générés par le FPGA pour le calibrage du filtre tractable. Un CNA, 6, a notamment pour fonction de convertir en tension un code généré par le FPGA. La tension après amplification est appliquée sur le filtre tractable ou un filtre ayant un fonctionnement similaire pour faire varier la fréquence centrale.
L'exemple de la figure 1 est donné pour le calibrage d'un filtre tractable en tension par le biais du CNA, c'est-à-dire que sa fréquence centrale dépend de la tension qui lui est appliquée par le biais du CNA. Le FPGA ou tout autre composant contrôle le CNA par le biais de codes numériques. Le FPGA peut gérer l'émission des signaux qui vont être utilisés pour le calibrage.
Les différents composants sont commandés par le FPGA 4 dont un exemple détaillé est illustré en figure 7, ou un dispositif équivalent programmable contenant notamment un processeur configuré pour exécuter les étapes du procédé selon l'invention. Le dispositif comprend aussi le capteur de température 7 relié au FPGA afin de disposer de la valeur de température pour une valeur de fréquence et remonter au code pour le calibrage d'un composant.

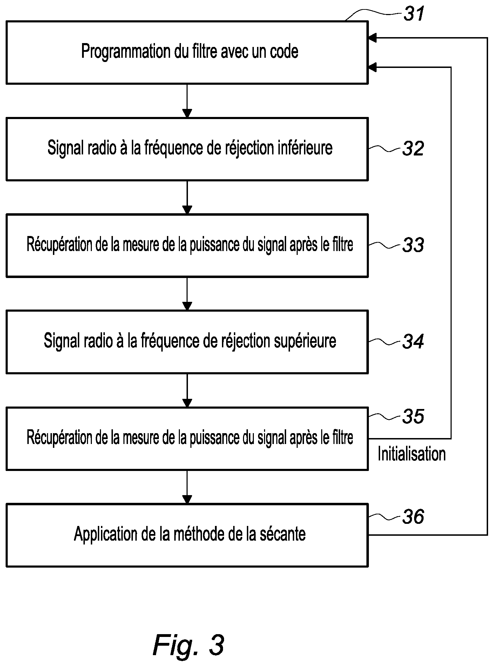

La figure 3 illustre un exemple d'étapes mises en œuvre pour le calibrage d'un filtre tractable.
Le FPGA lit, par exemple, la table de calibrage par défaut (mémorisée en EEPROM, par exemple), puis la table est copiée dans une mémoire de calcul interne au FPGA. Il peut aussi considérer une table de calibrage déjà présente dans le FPGA.
Lors d'une première étape 31, le FPGA programme le filtre à calibrer avec un code contenu dans la table de calibrage, par exemple,
**[0023]** Le FPGA va ensuite commander l'émission d'un premier signal radio à une fréquence de réjection inférieure à la fréquence centrale du filtre à calibrer, 32, puis il récupère la mesure de puissance du signal après le filtre, 33,
**[0024]** Le FPGA commande ensuite l'émission d'un deuxième signal radio à une fréquence de réjection supérieure à la fréquence centrale du filtre à calibrer 34, puis il récupère la mesure de puissance du signal après le filtre 35,
**[0025]** L'étape suivante consiste à appliquer la méthode de la sécante 36 pour calibrer le filtre, selon un processus itératif sur la fréquence de réjection inférieure et la fréquence de réjection supérieure.
Ces étapes sont par exemple répétées jusqu'à obtenir une table de calibrage complète, c'est-à-dire contenant les valeurs de calibrage pour plusieurs fréquences de référence.
Selon un autre mode de réalisation, à la place d'une table de calibrage, il est possible d'initialiser les étapes du procédé avec une valeur de code moyenne obtenue par exemple en réalisant une moyenne sur les codes mesurés, en utilisant des dispositifs de mesure externes et sur un échantillon représentatif des chaînes radio.
Un exemple est donné pour le calibrage automatique (sans avoir recours à un dispositif externe) d'un filtre tractable passe-bande. Le FPGA envoie un code au CNA qui le convertit en tension selon un principe connu de l'homme du métier. La tension est transmise à un amplificateur de commande qui l'amplifie et l'applique sur le filtre tractable ou un filtre dont la fréquence centrale peut varier. On obtient alors une table contenant les valeurs des codes aux températures requises et aux fréquences requises (de la table de calibrage). Sans sortir du cadre de l'invention, il est possible d'utiliser d'autres méthodes pour faire varier la fréquence centrale du filtre. Le calibrage des filtres tractables fait appel à une table de calibrage Code(fréquence, température) ou à une valeur de code moyenne. Pour chaque référence de la table de calibrage, on va trouver les codes optimaux qui permettent de centrer le filtre à calibrer, comme il est représenté à la figure 2. La partie gauche de la figure 2 illustre la valeur de puissance mesurée en sortie de filtre avant calibrage et la partie droite de la figure 2 illustre la valeur de puissance mesurée en sortie de filtre après calibrage et en utilisant le procédé selon l'invention.

Pour calibrer le filtre tractable, on va par exemple choisir une fréquence de référence. On effectue ensuite la mesure de la puissance atténuée aux fréquences de réjection. On trouve ensuite le code $c_i$ permettant d'équilibrer le filtre par la méthode de la sécante, selon des étapes connues de l'homme du métier, puis on effectue une extrapolation polynomiale d'ordre 6, par exemple, afin de transposer les codes trouvés à température ambiante aux températures de référence de la table de calibrage, par exemple aux températures de référence indiquées dans la table de calibrage. Toute fonction permettant une extrapolation pourra être utilisée, telle qu'une fonction linéaire, polynomiale, etc.

Le procédé de calibrage selon l'invention va, par exemple, effectuer plusieurs mesures de puissance pour calibrer un ou plusieurs filtres tractables. L'algorithme d'auto-calibrage mis en œuvre dans le FPGA exécute les étapes détaillées ci-après.

Pour chaque filtre à calibrer, pour chaque position, à température ambiante $T_{amb}$, pour chaque fréquence $(f_i)$ de la table de calibrage, le FPGA détermine le code $c_i(T_i, f_i)$ qui va permettre de centrer le filtre tractable à calibrer sur cette fréquence $(f_i)$ de la table de calibrage. Pour chaque mesure de puissance $P_i$ (effectuée par exemple en sortie de la chaîne radio) on mémorise la température $T_i$ correspondante à la mesure de puissance qui a été effectuée dans la mémoire du FPGA.

L'algorithme exécuté par le FPGA va chercher à équilibrer les points de réjections d'un filtre à calibrer, en considérant une première fréquence $(f_{i-})$ et une deuxième fréquence $(f_{i+})$. La valeur $(f_{i-})$ peut être égale à $(f_i - \varepsilon)$ ou à $(f_i - f_i * \varepsilon)$ et $(f_{i+})$ à $(f_i + \varepsilon)$ à $(f_i + f_i * \varepsilon)$. La valeur de $\varepsilon$ sera choisie en fonction du composant à calibrer et de l'application radio. Par exemple, dans le cas d'un filtre passe-bande, $\varepsilon$ sera choisi de façon à ce que la puissance du signal à la fréquence centrale $f_i$ soit maximale lorsque les puissances aux deux fréquences de réjection précédemment définies sont égales. Il pourra être déterminé de façon empirique, théorique ou par la modélisation des filtres à calibrer. La valeur de $\varepsilon$ pourra être différente suivant la bande de fréquence ou suivant la fréquence de réjection considérée (inférieure ou supérieure).

Pour équilibrer les deux fréquences $f_{i-}$ et $f_{i+}$, le FPGA applique la méthode de la sécante connue de l'homme du métier. On va rechercher le « 0 » de la fonction :

$$g(c) = P_c(f_{i+}) - P_c(f_{i-})$$

où $P_c(f)$ est la puissance mesurée à la fréquence f lorsque le code c est programmé. Il s'agit de la réponse fréquentielle du filtre à la fréquence f. On dispose alors d'une mesure de puissance à la fréquence de réjection inférieure à la fréquence $f_i$ et une mesure de puissance à la fréquence de réjection supérieure à la fréquence $f_i$.

Le procédé initialise deux valeurs de code proches des valeurs de codes pour une température donnée et contenues dans la table de calibrage prédéfinie ou dans une table de calibrage obtenue lors de la mise en œuvre du procédé selon l'invention. Le FPGA considère la table de calibrage initiale obtenue, par exemple, lors d'une étape de calibrage antérieure. La mesure de la température ambiante est effectuée par le capteur de température en liaison avec le FPGA puis, ce dernier va rechercher dans la table de calibrage, la valeur du code correspondant à la fréquence recherchée, pour une température inférieure à la température ambiante dans la table de calibrage. Le code trouvé correspond au premier point:

$$- g_1 \leftarrow g(code_1)$$

$$- nb_{iteration} \leftarrow limite\ ITER$$

- Tant que $abs(code_2 - code_1) > limite\ PREC$ et que $nb_{iteration} > 0$ alors

$$- g_2 \leftarrow g(code_2).$$

$$- code_3 \leftarrow code_2 + \frac{code_2 - code_1}{g_2 - g_1} g_2$$

$$- code_1 \leftarrow code_2$$

$$- code_2 \leftarrow code_3$$

$$- g_1 \leftarrow g_2$$

- $nb_{iteration} \leftarrow nb_{iteration} - 1$, avec $nb_{iteration}$ le nombre d'itérations déjà effectuées,

La limite ITER correspond à un nombre d'itérations défini, par exemple, en fonction du temps maximal alloué à l'étape de calibrage ou de la résolution du composant utilisé pour mesurer la puissance. La limite PREC correspond à une valeur d'écart entre les codes et à un seuil de précision souhaité qui est notamment défini en fonction de la sensibilité du capteur de température.

On obtient alors une suite de points permettant d'associer les fréquences de la table avec des codes et à des températures mesurées. Ensuite, on extrapole les mesures pour obtenir les codes aux niveaux de température requis contenus dans la table de calibrage et non plus à la température de mesure. L'étape d'extrapolation est exécutée selon un principe connu de l'homme du métier.

On obtient alors une table contenant les valeurs des codes aux températures requises et aux fréquences requises (fréquences de la table de calibrage). Cette table sera stockée par le FPGA pour une utilisation ultérieure. Pour une fréquence positionnée entre deux fréquences, mais qui n'est pas contenue dans la table de calibrage, le FPGA programme le signal radio aux fréquences de réjections utilisées lors des étapes et réalise une interpolation avec pour entrées le code de la fréquence de référence inférieure et le code de la fréquence de référence supérieure à la fréquence souhaitée, i.e., fréquence centrale.

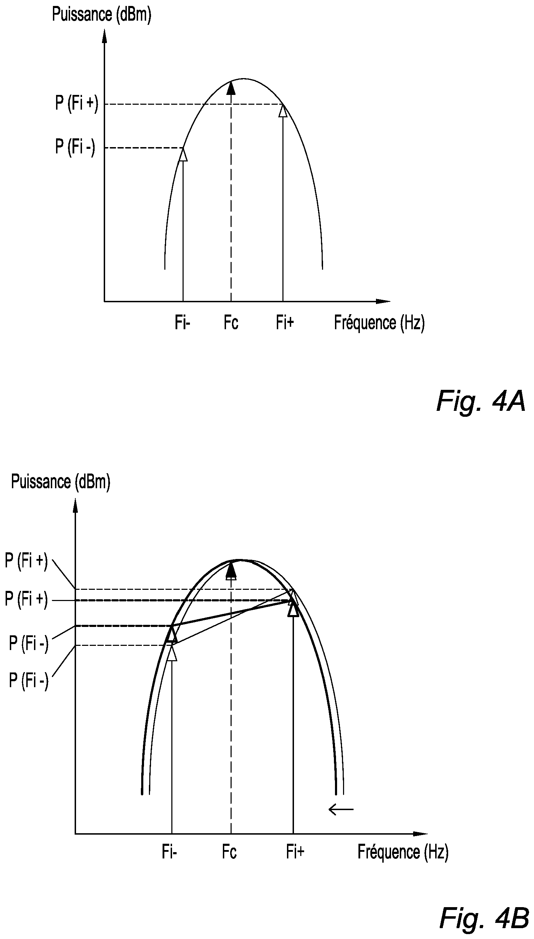

La figure 4A illustre la mesure de puissance en sortie d'un filtre à l'initialisation et la figure 4B la mesure de puissance en sortie d'un filtre et le calibrage en utilisant la méthode de la sécante. Pour que le signal à la fréquence centrale ait une puissance maximale, on cherche à équilibrer le filtre en ayant des puissances aux fréquences de réjection $f_{i-}$ et $f_{i+}$ égales.

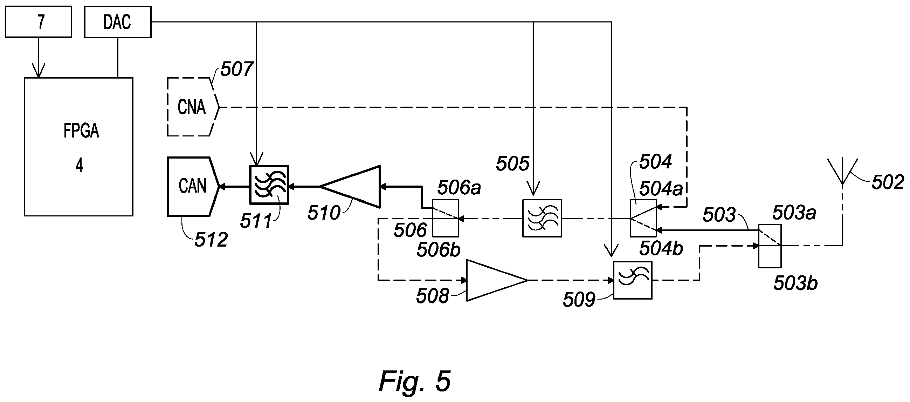

La figure 5 schématise un exemple de dispositif radiofréquence 501 équipé d'un procédé selon l'invention pour réaliser l'autocalibrage des composants de la chaîne, par exemple, le calibrage des filtres.

Une antenne 502 permettant l'émission et/ou la réception de signaux RF est en liaison avec un premier commutateur 503 pouvant prendre deux positions 503a et 503b afin de sélectionner la voie d'émission ou la voie de réception suivant un ordre donné. Un deuxième commutateur 504 et un troisième commutateur 506 sont aussi configurés pour prendre deux positions 504a, 504b, 506a, 506b, selon la voie sélectionnée, respectivement voie émission et voie réception. Ces deux commutateurs sont positionnés en amont d'un premier filtre 505 constituant ainsi une voie commune à la voie d'émission et à la voie de réception.

La voie d'émission comprend un convertisseur numérique analogique 507 relié par la voie commune à un amplificateur de signal 508 et à un filtre 509 positionné en amont de l'antenne.

La chaîne de réception comprend un amplificateur 510 suivi d'un filtre 511 et d'un convertisseur analogique numérique 512.

Les différents composants sont commandés par le FPGA 4 dont un exemple détaillé est illustré en figure 7 ou un dispositif équivalent programmable contenant notamment un processeur configuré pour exécuter les étapes du procédé selon l'invention. Le capteur de température 7 relié au FPGA permet de disposer de la valeur de température pour une valeur de fréquence et remonter au code pour le calibrage d'un composant.

La mise en œuvre du procédé selon l'invention est réalisée, par exemple, dans un composant programmable FPGA comprenant notamment des modules de commande permettant l'exécution du procédé selon l'invention. Pour cela, le FPGA peut utiliser une architecture de processeur pour FPGA connu sous le terme anglo-saxon « softcore ».

Cette architecture possède les avantages suivants :

- La flexibilité : il est possible de modifier l'algorithme sans remettre en cause l'architecture du FPGA,

- La versatilité : il est possible d'utiliser ce softcore pour d'autres besoins éventuels (canaux bouchés...),

- capacité de débogage (utilisation de point d'arrêt « breakpoint »),

- capacité d'accélération de mise au point : une modification de l'algorithme ne demande qu'une compilation (quelques dizaines de secondes) plutôt qu'une synthèse-placement-routage selon l'art antérieur (quelques dizaines de minutes).

Selon un autre mode de réalisation, il est possible d'envisager une architecture matériel pour la mise en œuvre du procédé selon l'invention basée sur l'utilisation de plusieurs machines d'états codées, par exemple, en langage de description matériel destiné à représenter le comportement ainsi que l'architecture numérique connu sous l'acronyme anglo-saxon suivant VHSIC Hardware Description Language, avec VHSIC = Very High Speed Integrated Circuit et des blocs de calcul codés en VHDL.

La figure 6 illustre un exemple d'agencement d'un FPGA détaillé à la figure 7 en liaison avec la chaîne radio de la figure 5 comprenant un module d'autocalibrage détaillé à la figure 7 permettant de calibrer un ou plusieurs composants.

La figure 7 illustre un exemple d'architecture de bloc dans le cas d'une implémentation matérielle.

Les blocs principaux sont les suivants:

- Autocal_comm 61 : permettant la communication entre le service du FPGA réalisant la gestion du calibrage et les autres services du FPGA, et notamment le service qui s'occupe de convertir les demandes d'accès radio en commandes pour les composants radio analogiques. Dans un souci d'optimisation de ressources, on pourra y ajouter une machine d'état permettant de partager un nœud émetteur TX.

- Fsm_autocal_main 62: machine à état principale permettant de contrôler les étapes principales de l'auto-calibrage, notamment les étapes d'initialisation et de finalisation de l'opération ainsi que les incréments dans les configurations de la chaîne radiofréquence.

- Fsm_autocal_balance 63 : machine à état mettant en place l'algorithme « d'équilibrage » des deux fréquences de coupure, elle implémente la méthode de la sécante. L'équilibrage d'un filtre est connu de l'homme du métier. Lorsque le filtre est centré sur sa fréquence centrale, les niveaux de puissances aux fréquences de réjection sont égaux.

- Polynom_horner 64: bloc de calcul permettant d'évaluer un polynôme. Ce bloc permet d'évaluer un polynôme et de déporter le calcul de l'extrapolation en température.

- Autocal_mem 65 : mémoire de calcul étant une copie de la mémoire contenant la carte de calibrage. Elle est chargée à l'initialisation de l'opération d'auto-calibrage, elle est utilisée en tant que mémoire de calcul par le bloc fsm_autocal_balance. Lorsque l'opération est terminée, elle est recopiée dans la mémoire d'origine contenant la table de calibrage afin de rendre le résultat persistant.

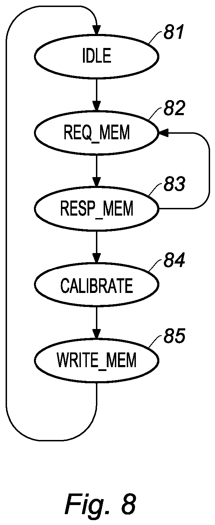

La machine à état fsm_autocal_main 62 peut être représentée par le diagramme de la figure 8.

Dans l'état IDLE, 81, la machine attend une commande de démarrage de l'opération d'auto-calibrage. À la réception de ce message, la machine à états finis ou FSM demande au service du FPGA qui gère les composants radio de passer en mode auto-calibrage (démarrage du CNA avec des échantillons à -30 dBm).

Dans l'état REQ_MEM, 82, la machine d'état récupère la table de calibrage dans sa mémoire de stockage.

Dans l'état RESP_MEM, 83, la machine d'état attend que la réponse à la requête précédemment générée arrive. Ensuite, elle écrit cette réponse dans la mémoire autocal_mem. La machine part dans l'état CALIBRATE si toute la table a été chargée, sinon elle repart en REQ_MEM.

Dans l'état CALIBRATE, 84, la machine déclenche des requêtes vers la machine d'état secondaire (fsm_autocal_balance) successivement pour chaque fréquence à calibrer.

La machine profite de l'état CALIBRATE pour configurer les discrets de manière à réaliser cette configuration. Lorsque toutes les configurations ont été calculées, la machine passe dans l'état WRITE_MEM.

Dans l'état WRITE_MEM, 85, la machine réécrit en EEPROM la mémoire précédemment calculée.

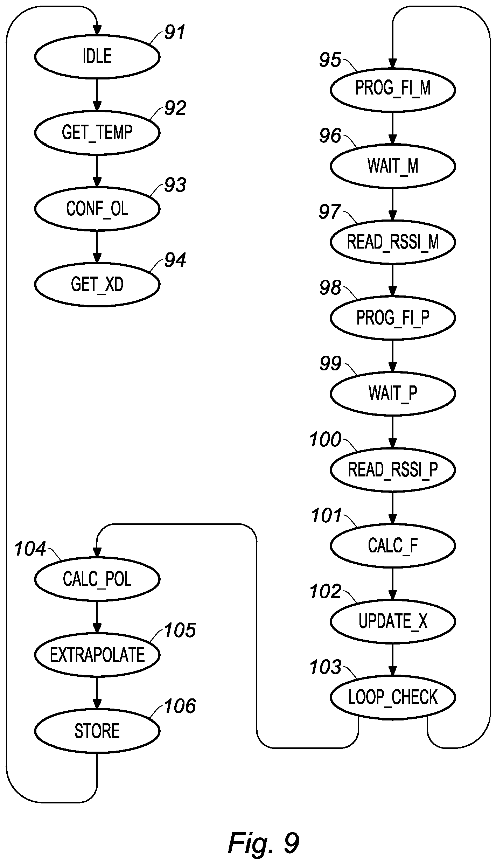

La machine à état fsm_autocal_balance peut être représentée par le diagramme illustré à la figure 9.

Dans l'état IDLE, 91, la machine attend une commande de démarrage de l'opération d'équilibrage des fréquences avec les numéros de filtre, configuration et fréquence (provenant de la fsm_autocal_main). À la réception de cette commande, la FSM fait une requête de température.

Dans l'état GET_TEMP, 92, la machine attend une réponse à la requête de température précédemment envoyée et stocke la valeur reçue qui servira pour l'extrapolation en température.

Dans l'état CONF_OL, 93, la machine mémorise les configurations.

Dans l'état GET_X0, 94, la machine à état récupère le code correspondant à la fréquence demandée à la température directement inférieure à la température ambiante et le stocke dans un registre X.

Dans l'état PROG_FI_M, 95, la machine d'état configure les OL pour la fréquence $f_{i-}$.

Dans l'état WAIT_M, 96, la machine d'état attend pour que toutes les valeurs à mesurer soient stables. La valeur de la puissance mesurée est récupérée.

Dans l'état READ_RSSI_M, 97, la machine d'état récupère les valeurs des puissances (les valeurs brutes peuvent suffire, il n'y a pas besoin de convertir ces valeurs en dBm).

Dans l'état PROG_FI_P, 98, la machine d'état configure les OL pour la fréquence $f_{i+}$.

Dans l'état WAIT_P, 99, la machine d'état attend pour que toutes les valeurs à mesurer soient stables. Lorsque le temps est écoulé, une requête de puissance est envoyée.

Dans l'état READ_RSSI_P, 100, la machine d'état récupère les valeurs des puissances.

Dans l'état CALC_F, 101, la machine calcule la valeur de la fonction (). Cette valeur est la différence des puissances reçues.

Dans l'état UPDATE_X, 102, la machine a un comportement différent selon s'il s'agit de son premier passage depuis l'état IDLE :

- Dans le cas du premier passage, la machine récupère le code correspondant à la fréquence demandée à la température directement inférieure à la température ambiante et le stocke dans le registre X, le registre X dans X_prev et la valeur de F dans F_prev.

- Dans le cas d'un autre passage, la machine calcule X selon la formule de la sécante et stocke cette nouvelle valeur dans X, tandis que X est stocké dans X_prev et F dans F_prev.

Dans l'état LOOP_CHECK, 103, la machine vérifie l'écart entre X et X_prev ainsi que le nombre d'itération et choisi le prochain état en fonction.

Dans l'état CALC_POL, 104, la machine attend la valeur du polynôme associé au filtre pour la fréquence donnée. Cette valeur sera utilisée pour l'extrapolation. La valeur du polynôme est calculée par un bloc extérieur.

Dans l'état, EXTRAPOLATE, 105, la machine effectue l'opération permettant le calcul d'extrapolation en tenant compte de la température mesurée et de la température recherchée.

Dans l'état STORE, 106, le résultat de l'extrapolation est stocké en mémoire, le calcul est réitéré pour chaque température recherchée. Quand toutes les températures sont traitées, la machine repasse en état IDLE en envoyant un acquittement à la machine fsm_autocal_main.

L'invention offre un procédé de calibrage rapide, qui ne nécessite pas d'utilisation de dispositifs externes.

**Revendications**

**1.** Procédé pour calibrer un filtre dont la valeur de fréquence centrale est variable en utilisant une table de calibrage associant une valeur de code à une valeur de fréquence et à une valeur de température, **caractérisé en ce qu'**il comporte au moins les étapes suivantes :

- Pour chaque valeur de fréquence de la table de calibrage, déterminer les valeurs de codes appliqués sur le filtre permettant de centrer le filtre à calibrer en exécutant les étapes suivantes :

Appliquer un code $code_1$ *(soit i - 1)* sur le filtre à calibrer
Envoyer un signal à la fréquence de réjection supérieure à une fréquence choisie sur le filtre,
Mesurer la puissance reçue à la sortie du filtre,

Envoyer un signal à la fréquence de réjection inférieure de ladite fréquence choisie sur le filtre,
Mesurer la puissance reçue à la sortie du filtre,
Exécuter les étapes suivantes :

- $g_{i-1} \leftarrow g(code_{i-1})$
- $nb_{iteration} = 0$
- Tant que $abs(code_i - code_{i-1}) >$ *limite PREC* et que $nb_{iteration} <$ *limite ITER* alors

Appliquer un code $code_2$ *(i - 1=1, i = 2)* sur le filtre à calibrer Envoyer un signal à la fréquence de réjection supérieure de la fréquence choisie sur le filtre
Mesurer la puissance du signal reçu à la sortie du filtre Envoyer un signal à la fréquence de réjection inférieure de la fréquence choisie sur le filtre
Mesurer la puissance reçue à la sortie du filtre
Effectuer les calculs suivants :

- $g_i \leftarrow g(code_i)$.
- $$code_{i+1} \leftarrow code_i + \frac{code_i - code_{i-1}}{g_i - g_{i-1}} g_i$$
- $code_{i-1} \leftarrow code_i$
- $code_i \leftarrow code_{i+1}$
- $g_{i-1} \leftarrow g_i$
- $nb_{iteration} \leftarrow nb_{iteration} + 1$

avec :

◦ *limite ITER* correspond à un nombre d'itérations fixé,
◦ *limite PREC* correspond à une valeur d'écart entre les codes et à un seuil de précision souhaité,
◦ où $g(x)$ est définie comme $g_x \leftarrow P_x(f_{i+}) - P_x(f_{i-})$, avec

◦ $P_x(f_{i+})$ la puissance mesurée à la fréquence de réjection supérieure de la fréquence considérée lorsque le code $code_x$ est appliqué sur le filtre,
◦ $P_x(f_{i-})$ la puissance mesurée à la fréquence de réjection inférieure de la fréquence considérée lorsque le code $code_x$ est appliqué sur le filtre,

◦ $code_i$ correspond au code considéré, $code_{i-1}$ correspond au code précédent
◦ $nb_{iteration}$ correspond au nombre d'itérations déjà effectuée,

Sélectionner la valeur du $code_i$ si elle vérifie $(code_i - code_{i-1}) <$ limite PREC et associer ladite valeur à ladite fréquence,

- Réitérer lesdites étapes pour chaque fréquence contenue dans la table de calibrage, et définir une table associant une fréquence pour chaque code,
- Utiliser ladite table pour calibrer ledit filtre.

**2.** Procédé selon la revendication 1 **caractérisé en ce qu'**il comporte en outre les étapes suivantes :

- Mesurer la température ambiante,
- Extrapoler les mesures afin d'obtenir les codes pour l'ensemble des températures de référence de la table de calibrage.

**3.** Procédé selon l'une des revendications 1 ou 2 **caractérisé en ce que** pour initialiser les étapes, on utilise une valeur de code contenue dans une table de calibrage.

**4.** Procédé selon l'une des revendications 1 ou 2 **caractérisé en ce que** pour initialiser les étapes, on utilise une valeur de code moyennée.

**5.** Système pour calibrer un filtre à fréquence variable **caractérisé en ce qu'**il comporte un dispositif de gestion configuré pour faire varier la fréquence centrale dudit filtre (2), un capteur de température (7), un dispositif émetteur d'un signal, un dispositif (3) adapté à mesurer la valeur de la puissance du signal après passage dans ledit filtre, un dispositif programmable (4) configuré pour exécuter les étapes du procédé selon l'une des revendications 1 à 4.

**6.** Système selon la revendication 5 **caractérisé en ce qu'**il comporte :

- une chaîne d'émission comprenant un convertisseur numérique analogique (507) relié à un amplificateur de signal (508) et à un filtre (509) positionné en amont d'une antenne (502),
- une chaîne de réception comprenant un amplificateur (510) positionné en amont d'un filtre dont la fréquence centrale est variable (511), et un convertisseur analogique numérique (512),
- ladite antenne est liée avec un premier commutateur (503) configuré pour prendre deux positions (503a, 503b) afin de sélectionner la voie d'émission ou la voie de réception suivant un ordre donné par un dispositif de gestion et de commande (513), un deuxième commutateur (504) et un troisième commutateur (506) configurés pour prendre deux positions (504a, 504b, 506a, 506b), selon la voie sélectionnée, respectivement voie émission et voie réception, lesdits deux commutateurs sont positionnés en amont d'un premier filtre (505) constituant ainsi une voie commune à la voie d'émission et à la voie de réception.

**7.** Système selon la revendication 5 **caractérisé en ce que** le dispositif de gestion et de commande est un dispositif de type FPGA configuré pour agir sur les commutateurs afin d'activer la chaîne d'émission ou la chaîne de calibrage et de contrôle du bon fonctionnement de la chaîne radio.

**8.** Système selon l'une des revendications 5 à 7 **caractérisé en ce qu'**il comporte un composant CNA relié au dispositif programmable de type FPGA, ledit CNA recevant un code émis par le FPGA afin de le convertir en une tension appliquée au filtre tractable afin de générer une table contenant les valeurs des codes aux températures requises et aux fréquences requises d'une table de calibrage.

**9.** Système selon l'une des revendications 5 à 8 **caractérisé en ce que** le filtre tractable est un filtre tractable passe-bande.


**Patentansprüche**

**1.** Verfahren zum Eichen eines Filters, dessen Mittenfrequenzwert variabel ist, unter Verwendung einer Eichtabelle, in der ein Codewert einem Frequenzwert und einem Temperaturwert zugeordnet ist, **dadurch gekennzeichnet, dass** es mindestens die folgenden Schritte umfasst:

- Bestimmen, für jeden Frequenzwert der Eichtabelle, der auf das Filter angewandten Codewerte, wodurch das zu eichende Filter zentriert werden kann, unter Ausführung der folgenden Schritte:

Anwenden eines Codes $code_1$, also (i - 1) auf das zu eichende Filter,

Senden eines Signals mit der Sperrfrequenz, die höher ist als eine ausgewählte Frequenz, an den Filter, Messen der am Ausgang des Filters empfangenen Leistung,
Senden eines Signals mit der Sperrfrequenz, die niedriger ist als die ausgewählte Frequenz, an den Filter,
Messen der am Ausgang des Filters empfangenen Leistung,
Ausführen der folgenden Schritte:

- $g_{i-1} \leftarrow g(code_{i-1})$
- $nb_{iteration} = 0$
- wenn $abs(code_i - code_{i-1}) > limite\ PREC$ und $nb_{iteration} < limite\ ITER$, dann

Anwenden eines Codes $code_2$ (i --1=1, i = 2) auf den zu eichenden Filter,
Senden eines Signals mit der Sperrfrequenz, die höher ist als die ausgewählte Frequenz, an den Filter,
Messen der am Ausgang des Filters empfangenen Signalleistung,
Senden eines Signals mit der Sperrfrequenz, die niedriger ist als die ausgewählte Frequenz an den Filter
Messen der am Ausgang des Filters empfangenen Leistung,

Ausführen der folgenden Berechnungen:

- $g_i \leftarrow g(code_i)$.

$$code_{i+1} \leftarrow code_i + \frac{code_i - code_{i-1}}{g_i - g_{i-1}} g_i$$

- $code_{i-1} \leftarrow code_i$
- $code_i \leftarrow code_{i+1}$
- $g_{i-1} \leftarrow g_i$
- $nb_{iteration} \leftarrow nb_{iteration} + 1$

wobei:

○ *limite ITER* einer Anzahl von festgelegten Wiederholungen entspricht,
○ *limite PREC* einem Wert des Unterschieds zwischen den Codes und einer gewünschten Präzisionsschwelle entspricht,
○ wobei *g(x)* definiert ist als $g_x \leftarrow P_x(f_{i+}) - P_x(f_{i-})$, wobei
○ $P_x(f_{i+})$ die an der Sperrfrequenz, die höher ist als die betreffende Frequenz gemessene Leistung ist, wenn der Code $code_x$ auf das Filter angewandt wird,
○ $P_x(f_{i-})$ die an der Sperrfrequenz, die niedriger ist als die betreffende Frequenz gemessene Leistung ist, wenn der Code $code_x$ auf das Filter angewandt wird,
○ $code_i$ dem betreffenden Code entspricht, $code_{i-1}$ dem vorhergehenden Code entspricht,
○ $nb_{iteration}$ der Anzahl der bereits vorgenommenen Iterationen entspricht,

Auswählen des Wertes des $code_i$, wenn er $(code_i - code_{i-1}) < limite\ PREC$ erfüllt, und Zuordnen des Wertes zu der Frequenz,

- Wiederholen der Schritte für jede in der Eichtabelle enthaltene Frequenz und Definieren einer Tabelle, die eine Frequenz für jeden Code zuordnet,
- Verwenden der Tabelle zum Eichen des Filters.

2. Verfahren nach Anspruch 1, **dadurch gekennzeichnet, dass** es ferner die folgenden Schritte umfasst:

- Messen der Umgebungstemperatur,
- Extrapolieren der Messungen, um die Codes für die gesamten Referenztemperaturen der Eichtabelle zu erhalten.

3. Verfahren nach einem der Ansprüche 1 oder 2, **dadurch gekennzeichnet, dass** zum Einleiten der Schritte ein in einer Eichtabelle enthaltener Codewert verwendet wird.

4. Verfahren nach einem der Ansprüche 1 oder 2, **dadurch gekennzeichnet, dass** zum Einleiten der Schritte ein gemittelter Codewert verwendet wird.

5. System zum Eichen eines Filters mit variabler Frequenz, **dadurch gekennzeichnet, dass** es eine Verwaltungsvorrichtung, die zum Variieren der Mittenfrequenz des Filters (2) konfiguriert ist, einen Temperatursensor (7), eine Signalausgabevorrichtung, eine Vorrichtung (3), die zum Messen des Signalleistungswertes nach Durchgang in dem Filter geeignet ist, eine programmierbare Vorrichtung (4), die zum Ausführen der Schritte des Verfahrens nach einem der Ansprüche 1 bis 4 konfiguriert ist, umfasst.

6. System nach Anspruch 5, **dadurch gekennzeichnet, dass** es Folgendes umfasst:

- eine Aussendungskette, umfassend einen Analog-Digitalwandler (507), der mit einem Signalverstärker (508) und einem stromaufwärts einer Antenne (502) positionierten Filter (509) verbunden ist,
- eine Empfangskette, umfassend einen Verstärker (510), der stromaufwärts eines Filters positioniert ist, dessen Mittenfrequenz variabel ist (511), und einen Analog-Digitalwandler (512),
- wobei die Antenne mit einem ersten Schalter (503), der dafür konfiguriert ist, zwei Positionen (503a, 503b) einzunehmen, um den Aussendungsweg oder den Empfangsweg gemäß einer Reihenfolge zu wählen, die durch eine Verwaltungs- und Steuervorrichtung (513) vorgegeben ist, einem zweiten Schalter (504) und einem dritten Schalter (506) verknüpft ist, die dafür konfiguriert sind, zwei Positionen (504a, 504b, 506a, 506b) gemäß dem gewählten Weg, dem Aussendungsweg bzw. Empfangsweg, einzunehmen, wobei die beiden Schalter stromaufwärts eines ersten Filters (505) positioniert sind, wobei somit ein gemeinsamer Weg für den Aussendungsweg und den Empfangsweg gebildet wird.

**7.** System nach Anspruch 5, **dadurch gekennzeichnet, dass** die Verwaltungs- und Steuervorrichtung eine Vorrichtung vom FPGA-Typ ist, die dafür konfiguriert ist, auf die Schalter einzuwirken, um die Aussendungskette oder die Eich- und Steuerkette für ein korrektes Funktionieren der Funkkette zu aktivieren.

**8.** System nach einem der Ansprüche 5 bis 7, **dadurch gekennzeichnet, dass** es ein DAC-Bauteil umfasst, das mit der programmierbaren FPGA-Vorrichtung verbunden ist, wobei der DAC einen von der FPGA ausgegebenen Code empfängt, um diesen in eine an das abstimmbare Filter angelegte Spannung umzuwandeln, um eine Tabelle zu erzeugen, die die Codewerte bei den erforderlichen Temperaturen und den erforderlichen Frequenzen einer Eichtabelle enthält.

**9.** System nach einem der Ansprüche 5 bis 8, **dadurch gekennzeichnet, dass** das abstimmbare Filter ein abstimmbares Bandpassfilter ist.

**Claims**

**1.** A method for calibrating a filter, the value of the central frequency of which is variable, using a calibration table in which a code value is associated with a frequency value and with a temperature value, **characterised in that** it has at least the following steps:

- for each frequency value of the calibration table, determining the values of codes applied to the filter allowing the filter to be calibrated to be centred, by executing the following steps:

applying a code $code_1$ *(that is i - 1)* to the filter to be calibrated,
sending a signal at the rejection frequency, which is above a chosen frequency, to the filter,
measuring the power received at the output of the filter
sending a signal at the rejection frequency, which is below said chosen frequency, to the filter,
measuring the power received at the output of the filter
executing the following steps:

- $g_{i-1} \leftarrow g(code_{i-1})$
- $nb_{iteration} = 0$
- as long as $abs(code_i - code_{i-1}) > limit\ PREC$ and $nb_{iteration} < limit\ ITER$ then

applying a code $code_2$ ($i - 1 = 1$, $i = 2$) to the filter to be calibrated
sending a signal at the rejection frequency, which is above a chosen frequency, to the filter,
measuring the power of the signal received at the output of the filter
sending a signal at the rejection frequency, which is below said chosen frequency, to the filter,
measuring the power received at the output of the filter
performing the following computations:

- $g_i \leftarrow g(code_i)$.
- $$code_{i+1} \leftarrow code_i + \frac{code_i - code_{i-1}}{g_i - g_{i-1}} g_i$$
- $code_{i-1} \leftarrow code_i$
- $code_i \leftarrow code_{i+1}$
- $g_{i-1} \leftarrow g_i$
- $nb_{iteration} \leftarrow nb_{iteration} + 1$

where:

∘ *limit ITER* corresponds to a set number of iterations,

◦ *limit PREC* corresponds to a value of the difference between the codes and with a desired precision threshold,

◦ where *g(x)* is defined as $g_x \leftarrow P_x(f_{i+}) - P_x(f_{i-})$ with

◦ $P_x(f_{i+})$ is the power measured at the rejection frequency, which is above the frequency considered when the code $code_x$ is applied to the filter,

◦ $P_x(f_{i-})$ is the power measured at the rejection frequency, which is below the frequency considered when the code $code_x$ is applied to the filter

◦ $code_i$ corresponds to the considered code, and $code_{i-1}$ corresponds to the preceding code,

◦ $nb_{iteration}$ corresponds to the number of iterations already carried out,

selecting the value of the code; if it respects (code; - code$_{i-1}$) < limit PREC and associating said value with said frequency,

- reiterating said steps for each frequency contained in the calibration table, and defining a table in which a frequency is associated with each code
- using said table to calibrate said filter.

2. The method according to claim 1 **characterised in that** is further has the following steps:

   - measuring the ambient temperature,
   - extrapolating the measurements in order to obtain the codes for all of the reference temperatures of the calibration table.

3. The method according to either of claims 1 and 2, **characterised in that**, to initialize the steps, a code value contained in a calibration table is used.

4. The method according to either of claims 1 and 2, **characterised in that**, to initialise the steps, an averaged code value is used.

5. A system for calibrating a variable-frequency filter, **characterised in that** it comprises a managing device that is configured to make the central frequency of said filter (2) vary, a temperature sensor (7), a device for emitting a signal, a device (3) suitable for measuring the value of the power of the signal after passage through said filter, a programmable device (4) configured to execute the steps of the method according to one of claims 1 to 4.

6. System according to claim 5, **characterised in that** it has:

   - an emitting chain comprising a digital-analogue converter (507) connected to a signal amplifier (508) and to a filter (509) positioned upstream of an antenna (502),
   - a receiving chain comprising an amplifier (510) positioned upstream of a filter (511) the central frequency of which is variable, and an analogue-digital converter (512),
   - said antenna is connected to a first switch (503) that is configured to take two positions (503a, 503b) in order to select the emitting channel or the receiving channel in an order set by a managing and controlling device (513), a second switch (504) and a third switch (506), which are configured to take two positions (504a, 504b, 506a, 506b) depending on the channel selected, respectively the emitting channel and receiving channel, said two switches are positioned upstream of a first filter (505) thus forming a channel that is common to the emitting channel and to the receiving channel.

7. The system according to claim 5, **characterised in that** the managing and controlling device is a device of FPGA type configured to act on the switches in order to activate the emitting chain or the chain for calibrating and inspecting the correct operation of the radio chain.

8. The system according to one of claims 5 to 7, **characterised in that** it has a DAC component connected to the programmable device of FPGA type, said DAC receiving a code emitted by the FPGA in order to convert it into a voltage applied to the tunable filter in order to generate a table containing the values of the codes at the required temperatures and at the required frequencies of a calibration table.

9. The system according to one of claims 5 to 8, **characterised in that** the tunable filter is a tunable bandpass filter.

Fig. 1

Code C1

Puissance (dBm)

Calibrage

Fréquence (Hz)

Fvoulue

Code C2

Puissance (dBm)

Fréquence (Hz)

Fvoulue

Fig. 2

EP 3 675 356 B1

Fig. 3

Fig. 4A

Fig. 4B

*Fig. 5*

*Fig. 6*

*Fig. 7*

*Fig. 8*

*Fig. 9*

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7932844 B
- US 2013065542 A1
- US 2010244945 A1